(19) Europäisches Patentamt
European Patent Office
Office européen des brevets

(11) **EP 3 435 170 B1**

(12) **FASCICULE DE BREVET EUROPEEN**

(45) Date de publication et mention
de la délivrance du brevet:
**30.06.2021   Bulletin 2021/26**

(51) Int Cl.:
**G04B 31/02** *(2006.01)*        **G04B 17/04** *(2006.01)*
**G04B 17/28** *(2006.01)*        **G04B 31/06** *(2006.01)*
**B81B 3/00** *(2006.01)*

(21) Numéro de dépôt: **17183666.1**

(22) Date de dépôt: **28.07.2017**

(54) **OSCILLATEUR D'HORLOGERIE À GUIDAGES FLEXIBLES À GRANDE COURSE ANGULAIRE**

UHRWERKOSZILLATOR MIT FLEXIBLEN FÜHRUNGEN MIT GROSSER WINKELFÖRMIGER LAUFBAHN

TIMEPIECE OSCILLATOR HAVING FLEXIBLE GUIDES WITH WIDE ANGULAR TRAVEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**30.01.2019   Bulletin 2019/05**

(73) Titulaire: **The Swatch Group Research and Development Ltd**
**2074 Marin (CH)**

(72) Inventeurs:
• **Di Domenico, Gianni**
**2000 Neuchâtel (CH)**
• **Léchot, Dominique**
**2722 Les Reussilles (CH)**
• **Favre, Jérôme**
**2000 Neuchâtel (CH)**
• **Hinaux, Baptiste**
**1005 Lausanne (CH)**
• **Born, Jean-Jacques**
**1110 Morges (CH)**
• **Helfer, Jean-Luc**
**2525 Le Landeron (CH)**
• **Winkler, Pascal**
**2072 St-Blaise (CH)**

(74) Mandataire: **ICB SA**
**Faubourg de l'Hôpital, 3**
**2001 Neuchâtel (CH)**

(56) Documents cités:
**EP-A1- 3 035 127        EP-A1- 3 130 966**
**WO-A1-2017/055983    CH-A2- 709 536**
**US-A- 3 628 781**

• **M H KAHROBAIYAN ET AL: "Gravity insensitive flexure pivots for watch oscillators", CONGRÈS INTERNATIONAL DE CHRONOMÉTRIE - INTERNATIONAL CONFERENCE ON CHRONOMETRY 2016, 28 septembre 2016 (2016-09-28), pages 49-55, XP055439685, Montreux**

**EP 3 435 170 B1**

**Description**

Domaine de l'invention

L'invention concerne un oscillateur mécanique d'horlogerie, comportant un premier élément support rigide, un deuxième élément inertiel massif, et, entre ledit premier élément support rigide et ledit deuxième élément inertiel massif au moins deux premières lames flexibles qui supportent ledit deuxième élément inertiel massif et sont agencées pour le rappeler vers une position de repos, ledit deuxième élément inertiel massif étant agencé pour osciller angulairement selon un plan d'oscillation autour de ladite position de repos, lesdites deux premières lames flexibles ne se touchant pas et leurs projections sur ledit plan d'oscillation se croisant, en position de repos, en un point de croisement, par lequel passe l'axe de rotation dudit deuxième élément inertiel massif perpendiculairement audit plan d'oscillation, et les encastrements desdites premières lames flexibles avec ledit premier élément support rigide et ledit deuxième élément inertiel massif définissant deux directions de lames parallèles audit plan d'oscillation et faisant entre elles, en position de repos, en projection sur ledit plan d'oscillation, un angle au sommet particulier.

L'invention concerne encore un mouvement d'horlogerie comportant au moins un tel oscillateur mécanique.

L'invention concerne encore une montre comportant un tel mouvement d'horlogerie.

L'invention concerne le domaine des oscillateurs mécaniques d'horlogerie comportant des guidages à lames flexibles assurant les fonctions de maintien et de rappel d'éléments mobiles.

Arrière-plan de l'invention

L'utilisation de guidages flexibles, notamment à lames souples, dans des oscillateurs mécaniques d'horlogerie, est rendue possible par des procédés d'élaboration, tels que « MEMS », « LIGA » ou similaires, de matériaux micro-usinables, tels que le silicium et ses oxydes, qui permettent une fabrication très reproductible de composants qui présentent des caractéristiques élastiques constantes dans le temps et une grande insensibilité aux agents extérieurs tels que température et humidité. Des pivots à guidage flexible, tels que décrits dans les demandes EP14199039 ou EP16155039 du même déposant, permettent notamment de remplacer le pivot d'un balancier classique, ainsi que le ressort-spiral qui lui est usuellement associé. La suppression des frottements de pivots permet d'augmenter substantiellement le facteur de qualité d'un oscillateur. Toutefois les pivots à guidage flexible ont généralement une course angulaire faible, de l'ordre de 10° à 20°, ce qui est très faible en comparaison de l'amplitude usuelle de 300° d'un balancier-spiral, et qui n'autorise pas leur combinaison directe avec des mécanismes d'échappement classiques, et notamment avec des arrêtoirs usuels tels qu'une ancre suisse ou similaire.

Lors du Congrès de Chronométrie de Montreux, Suisse, des 28 et 29 septembre 2016, l'équipe de M. H. Kahrobaiyan a abordé l'augmentation de cette course angulaire dans l'article « Gravity insensitive flexure pivots for watch oscillators », et il apparaît que la solution -complexe- envisagée n'est pas isochrone.

Le document EP3035127A1 au nom de même déposant SWATCH GROUP RESEARCH & DEVELOPMENT Ltd décrit un oscillateur d'horlogerie comportant une base de temps avec au moins un résonateur constitué par un diapason lequel comporte au moins deux parties mobiles oscillantes, lesdites parties mobiles étant fixées à un élément de liaison, que comporte ledit oscillateur, par des éléments flexibles dont la géométrie détermine un axe de pivotement virtuel de position déterminée par rapport audit élément de liaison, autour duquel axe de pivotement virtuel oscille ladite partie mobile respective, dont le centre de masse est confondu en position de repos avec ledit axe de pivotement virtuel respectif. Pour au moins une dite partie mobile, lesdits éléments flexibles sont constitués de lames élastiques croisées et s'étendant à distance l'une de l'autre dans deux plans parallèles, et dont les projections des directions sur un desdits plans parallèles se croisent au niveau dudit axe de pivotement virtuel, de ladite partie mobile considérée.

Le document US3628781A au nom de GRIB décrit une fourche de diapason, sous la forme d'une structure en porte-à-faux double, pour permettre un mouvement de rotation accentué d'une paire d'éléments mobiles, par rapport à un plan de référence fixe comprenant un premier corps élastiquement déformable ayant au moins deux parties flexibles allongées élastiquement similaires, les extrémités de chacune desdites parties flexibles étant respectivement solidaire de parties rigides agrandies dudit élément, la première desdites parties rigides étant fixée pour définir un plan de référence et la seconde étant supportée élastiquement pour avoir un mouvement de rotation accentué par rapport à la première, un second corps déformable élastiquement sensiblement identique au premier corps déformable élastiquement, et des moyens pour fixer rigidement les premières desdites parties rigides respectives desdits corps élastiquement déformables en relation espacée pour fournir une structure de fourche de diapason dans laquelle chacune des dents du diapason comprend l'extrémité libre de l'un desdits corps élastiquement déformables.

Le document EP3130966A1 au nom de ETA Manufacture Horlogère Suisse décrit un mouvement d'horlogerie mécanique qui comprend au moins un barillet, un ensemble de roues d'engrenage entraîné à une extrémité par le barillet, et un mécanisme d'échappement d'un oscillateur local avec un résonateur sous forme d'un balancier-spiral et un système de rétroaction du mouvement d'horlogerie. Le mécanisme d'échappement est entraîné à une autre extrémité de l'ensemble de roues d'engrenage. Le système de rétroaction comprend au moins un oscillateur de référence précis, combiné à un comparateur de marche pour comparer la marche des deux oscillateurs, et un mécanisme de réglage du résonateur de l'oscillateur local pour ralentir ou accélérer le résonateur sur la base d'un résultat de la comparaison dans le comparateur de marche.

Le document CH709536A2 au nom de ETA Manufacture Horlogère Suisse décrit un mécanisme régulateur d'horlogerie comportant, montés mobiles, au moins en pivotement par rapport à une platine, une roue d'échappement agencée pour recevoir un couple moteur via un rouage, et un premier oscillateur comportant une première structure rigide reliée à ladite platine par des premiers moyens de rappel élastique. Ce mécanisme régulateur comporte un deuxième oscillateur comportant une deuxième structure rigide reliée à ladite première structure rigide par des deuxièmes moyens de rappel élastique, et qui comporte des moyens de guidage agencés pour coopérer avec des moyens de guidage complémentaire que comporte ladite roue d'échappement, synchronisant ledit premier oscillateur et ledit deuxième oscillateur avec ledit rouage.

Résumé de l'invention

L'invention se propose de mettre au point un oscillateur mécanique à guidages flexibles, dont la course angulaire soit compatible avec des mécanismes d'échappement existants.

En considérant le cas particulier d'un guidage flexible à lames croisées en projection dans un plan parallèle au plan d'oscillation, où ces lames joignent une masse fixe et une masse mobile, la course angulaire possible θ du pivot dépend du rapport X= D/L entre, d'une part la distance D du point d'encastrement d'une lame dans la masse fixe et le point de croisement, et d'autre part la longueur totale L de cette même lame entre ses deux encastrements opposés. Les travaux cités ci-dessus de l'équipe de M. H. Kahrobaiyan montrent que cette course angulaire possible θ est, pour un couple de lames donné et d'angle au sommet α donné au point de croisement, ici de 90°, maximale pour X= D/L= 0.5, et décroît rapidement quand on s'écarte de cette valeur, selon une courbe sensiblement symétrique. Or un tel pivot à lames croisées avec X= D/L= 0.5 et a=90° n'est pas isochrone.

L'invention explore de ce fait les domaines de combinaisons favorables entre les valeurs d'angle au sommet α au croisement des lames, et les valeurs du rapport X= D/L, pour obtenir des pivots isochrones.

A cet effet, l'invention concerne un oscillateur mécanique selon la revendication 1.

Et notamment l'invention montre que l'on peut obtenir un oscillateur isochrone avec des pivots qui vérifient les deux inégalités : $0.15 \leq (X= D/L) \leq 0.85$, et $\alpha \leq 60°$.

Naturellement les configurations avec a=0° sont écartées, les lames n'étant alors plus sécantes en projection, mais parallèles.

L'invention concerne encore un mouvement d'horlogerie comportant au moins un tel oscillateur mécanique.

L'invention concerne encore une montre comportant un tel mouvement d'horlogerie.

Description sommaire des dessins

D'autres caractéristiques et avantages de l'invention apparaîtront à la lecture de la description détaillée qui va suivre, en référence aux dessins annexés, où :

- la figure 1 représente, de façon schématisée, et en perspective, une première variante d'oscillateur mécanique, qui comporte un premier élément support rigide, de forme allongée, pour sa fixation à une platine du mouvement ou similaire, auquel est suspendu un deuxième élément inertiel massif par deux premières flexibles disjointes, croisées en projection sur le plan d'oscillation de ce deuxième élément inertiel, lequel coopère avec un mécanisme d'échappement classique avec ancre suisse et roue d'échappement standard ;
- la figure 2 représente, de façon schématisée, et en plan, l'oscillateur de la figure 1 ;
- la figure 3 représente, de façon schématisée, et en coupe passant par l'axe de croisement des lames, l'oscillateur de la figure 1 ;
- la figure 4 représente, de façon schématisée, un détail de la figure 2, montrant le décalage entre le croisement des lames et la projection du centre de masse du résonateur ;
- la figure 5 est un graphe, avec en abscisse rapport X= D/L entre, d'une part la distance D du point d'encastrement d'une lame dans la masse fixe et le point de croisement, et d'autre part la longueur totale L de cette même lame entre ses deux encastrements opposés, et en ordonnées l'angle au sommet de croisement des lames flexibles, et qui définit deux courbes, inférieure et supérieure, en trait interrompu, qui bornent le domaine convenable entre ces paramètres pour assurer l'isochronisme, la courbe en trait plein correspondant à une valeur avantageuse ;
- la figure 6 représente, de façon similaire à la figure 1, une deuxième variante d'oscillateur mécanique, où le premier élément support rigide, de forme allongée, est aussi mobile par rapport à une structure fixe, et est porté par un troisième élément rigide, par l'intermédiaire d'un second jeu de lames flexibles, agencées de façon similaire au premières lames flexibles, le deuxième élément inertiel étant encore agencé pour coopérer avec un mécanisme d'échappement classique non représenté ;

- la figure 7 représente, de façon schématisée, et en plan, l'oscillateur de la figure 6;
- la figure 8 représente, de façon schématisée, et en coupe passant par l'axe de croisement des lames, l'oscillateur de la figure 1 ;
- la figure 9 est un schéma-blocs représentant une montre qui comporte un mouvement avec un tel résonateur.

Description détaillée des modes de réalisation préférés

L'invention concerne ainsi un oscillateur mécanique 100 d'horlogerie, comportant au moins un premier élément support rigide 4 et un deuxième élément inertiel massif 5. Cet oscillateur 100 comporte, entre le premier élément support rigide 4 et le deuxième élément inertiel massif 5, au moins deux premières lames flexibles 31, 32, qui supportent le deuxième élément inertiel massif 5, et qui sont agencées pour le rappeler vers une position de repos. Ce deuxième élément inertiel massif 5 est agencé pour osciller angulairement selon un plan d'oscillation autour de cette position de repos.

Les deux premières lames flexibles 31 et 32 ne se touchent pas, et, en position de repos, leurs projections sur le plan d'oscillation se croisent en un point de croisement P, par lequel passe l'axe de rotation du deuxième élément inertiel massif 5 perpendiculairement au plan d'oscillation. Tous les éléments géométriques décrits ci-après s'entendent, sauf mention contraire, comme étant considérés dans la position de repos de l'oscillateur à l'arrêt.

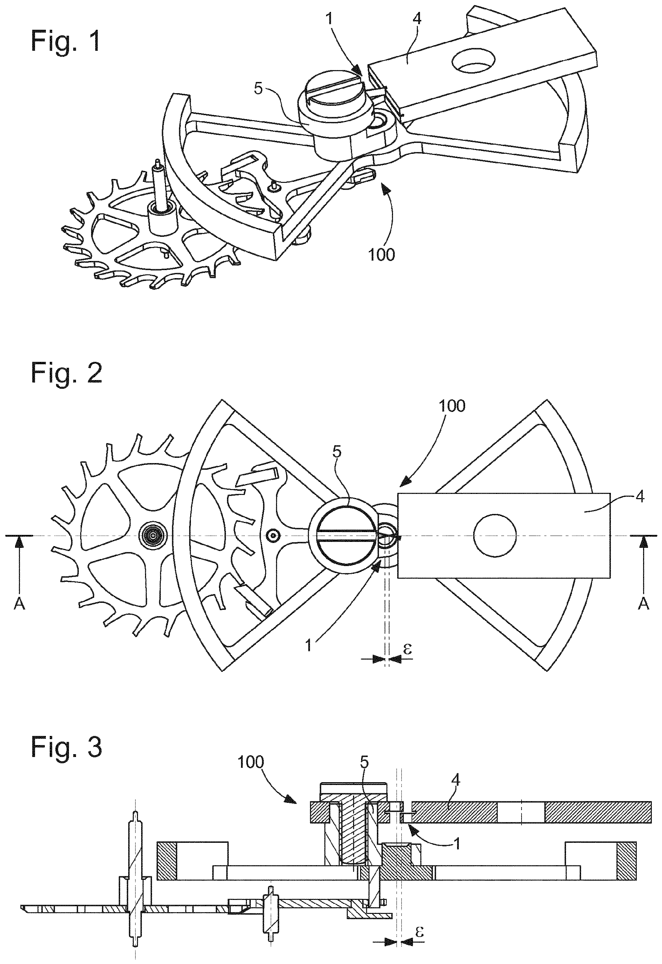

Les figures 1 à 4 illustrent une première variante avec un premier élément support rigide 4 et un deuxième élément inertiel massif reliés par deux premières lames flexibles 31, 32.

Les encastrements des premières lames flexibles 31, 32, avec le premier élément support rigide 4 et le deuxième élément inertiel massif 5 définissent deux directions de lames DL1, DL2, qui sont parallèles au plan d'oscillation et qui font entre elles, en projection sur le plan d'oscillation, un angle au sommet a.

Selon l'invention, la position du point de croisement P est définie par le rapport X= D/L où D est la distance entre la projection, sur le plan d'oscillation, de l'un des points d'encastrement des premières lames 31, 32, dans le premier élément de support rigide 4 et le point de croisement P, et où L est la longueur totale de la projection, sur le plan d'oscillation, de la lame 31, 32, concernée. Et la valeur du rapport D/L est comprise entre 0 et 1, et l'angle au sommet $\alpha$ est inférieur ou égal à 70°. Et les premières lames 31, 32, et leurs encastrements définissent ensemble un pivot 1 qui, en projection sur le plan d'oscillation, est symétrique par rapport à un axe de symétrie AA passant par le point de croisement P.

Plus particulièrement, les premières lames 31 et 32 sont des lames droites.

Plus particulièrement, l'angle au sommet $\alpha$ est inférieur ou égal à 60°. Plus particulièrement encore, l'angle au sommet $\alpha$ est inférieur ou égal à 50°, ou encore est inférieur ou égal à 40°, ou encore inférieur ou égal à 35°, ou encore inférieur ou égal à 30°.

Plus particulièrement, pour chaque première lame flexible 31, 32, le rapport d'encastrement D1/L1, D2/L2, est compris entre 0.15 et 0.85, bornes comprises. Plus particulièrement encore, ce rapport d'encastrement D1/L1, D2/L2, est compris entre 0.15 et 0.49, bornes comprises, ou entre 0.51 et 0.85, bornes comprises.

Dans une variante, l'angle au sommet $\alpha$ est inférieur ou égal à 50°, et le rapport d'encastrement D1/L1, D2/L2, est compris entre 0.25 et 0.75, bornes comprises.

Dans une autre variante, l'angle au sommet $\alpha$ est inférieur ou égal à 40°, et le rapport d'encastrement D1/L1, D2/L2, est compris entre 0.30 et 0.70, bornes comprises.

Dans une autre variante encore, l'angle au sommet $\alpha$ est inférieur ou égal à 35°, et le rapport d'encastrement D1/L1, D2/L2, est compris entre 0.40 et 0.60, bornes comprises.

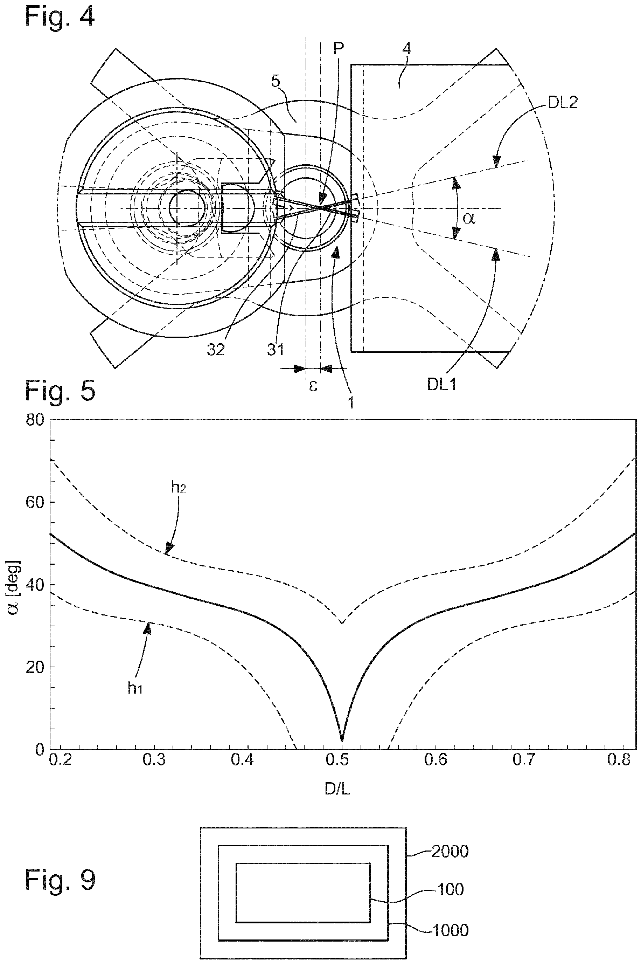

De façon avantageuse, et tel que visible sur la figure 5, l'angle au sommet $\alpha$ et le rapport X= D/L satisfont la relation :

h1(D/L) < a< h2(D/L), avec,
pour $0.2{\leq}X{<}0.5$ :

$$h1(X)= 116 - 473*(X + 0.05) + 3962*(X + 0.05)^3 - 6000*(X + 0.05)^4,$$

$$h2(X)=128 - 473*(X - 0.05) + 3962*(X - 0.05)^3 - 6000*(X - 0.05)^4,$$

pour $0.5{<}X{\leq}0.8$:

$$h1(X)= 116 - 473*(1.05 - X) + 3962*(1.05 - X)^3 - 6000*(1.05 - X)^4,$$

$$h2(X)=128 - 473*(0.95 - X) + 3962*(0.95 - X)^3 - 6000*(0.95 - X)^4.$$

Selon l'invention, en projection sur le plan d'oscillation, le centre de masse du deuxième élément inertiel massif 5 est situé sur l'axe de symétrie AA du pivot 1, et est situé à une distance non nulle du point de croisement P correspondant à l'axe de rotation dudit deuxième élément inertiel massif 5, aquelle distance est comprise entre 0.1 fois et 0.2 fois la longueur totale L de la projection, sur le plan d'oscillation, de la lame 31 ; 32.

Plus particulièrement, et notamment dans l'exécution non limitative illustrée par les figures, les premières lames flexibles 31 et 32 ont la même longueur L, et la même distance D.

Plus particulièrement, entre leurs encastrements, ces premières lames flexibles 31 et 32 sont identiques.

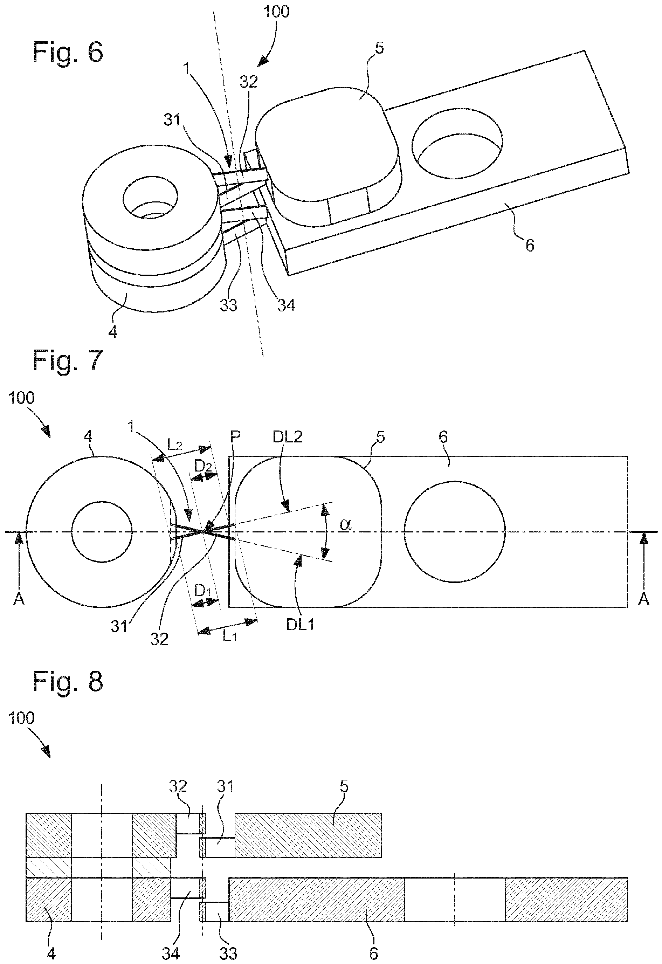

Les figures 6 à 8 illustrent une deuxième variante d'oscillateur mécanique 100, où le premier élément support rigide 4 est aussi mobile, directement ou indirectement par rapport à une structure fixe que comporte cet oscillateur 100, et est porté par un troisième élément rigide 6, par l'intermédiaire de deux secondes lames flexibles 33, 34, agencées de façon similaire au premières lames flexibles 31, 32.

Plus particulièrement, dans la réalisation non limitative illustré par les figures, les projections des premières lames flexibles 31, 32, et des secondes lames flexibles 33, 34, sur le plan d'oscillation se croisent au même point de croisement P.

Dans une autre forme particulière d'exécution non illustrée, en position de repos, en projection sur le plan d'oscillation, les projections des premières lames flexibles 31, 32, et des secondes lames flexibles 33, 34, sur le plan d'oscillation se croisent en deux points distincts tous deux situés sur l'axe de symétrie AA du pivot 1, quand le pivot 1 est symétrique par rapport à l'axe de symétrie AA.

Plus particulièrement, les encastrements des secondes lames flexibles 33, 34, avec le premier élément support rigide 4 et le troisième élément rigide 6, définissent deux directions de lames parallèles au plan d'oscillation et faisant entre elles, en projection sur le plan d'oscillation, un angle au sommet de même bissectrice que l'angle au sommet $\alpha$ que les premières lames flexibles 31, 32. Plus particulièrement encore, ces deux directions des secondes lames flexibles 33, 34, présentent le même angle au sommet $\alpha$ que les premières lames flexibles 31, 32.

Plus particulièrement, les secondes lames flexibles 33, 34, sont identiques aux premières lames flexibles 31, 32, comme dans l'exemple non limitatif des figures.

Plus particulièrement, quand le pivot 1 est symétrique par rapport à l'axe de symétrie AA, en position de repos, en projection sur le plan d'oscillation, le centre de masse du deuxième élément inertiel massif 5 est situé sur l'axe de symétrie AA du pivot 1.

De façon similaire et particulière, quand le pivot 1 est symétrique par rapport à l'axe de symétrie AA, en position de repos, le centre de masse du premier élément support rigide 4 est situé, en projection sur le plan d'oscillation, sur l'axe de symétrie AA du pivot 1.

Dans une variante particulière, quand le pivot 1 est symétrique par rapport à l'axe de symétrie AA, en position de repos, en projection sur le plan d'oscillation, à la fois le centre de masse du deuxième élément inertiel massif 5 et le centre de masse du premier élément support rigide 4 sont situés sur l'axe de symétrie AA du pivot 1. Plus particulièrement encore, les projections du centre de masse du deuxième élément inertiel massif 5 et du centre de masse du premier élément support rigide 4, sur l'axe de symétrie AA du pivot 1, sont confondues.

La configuration particulière et illustrée par les figures pour de tels pivots superposés est celle où les projections des premières lames flexibles 31, 32, et des secondes lames flexibles 33, 34, sur le plan d'oscillation se croisent au même point de croisement P, qui correspond aussi à la projection du centre de masse du deuxième élément inertiel massif 5, ou du moins qui en est la plus proche possible. Plus particulièrement ce même point correspond aussi à la projection du centre de masse du premier élément support rigide 4. Plus particulièrement encore, ce même point correspond aussi à la projection du centre de masse de l'oscillateur 100 tout entier.

Dans une variante particulière non illustrée de cette configuration de pivots superposés, quand le pivot 1 est symétrique par rapport à l'axe de symétrie AA, en position de repos, en projection sur le plan d'oscillation, le centre de masse du deuxième élément inertiel massif 5 est situé sur l'axe de symétrie AA du pivot 1, et à une distance non nulle du point de croisement correspondant à l'axe de rotation du deuxième élément inertiel massif 5, laquelle distance non nulle est comprise entre 0.1 fois et 0.2 fois la longueur totale L de la projection, sur le plan d'oscillation, de la lame 33, 34.

Selon l'invention, quand le pivot 1 est symétrique par rapport à l'axe de symétrie AA, le centre de masse du deuxième élément inertiel massif 5 est situé, en projection sur le plan d'oscillation, sur l'axe de symétrie AA du pivot 1 et à une distance non nulle du point de croisement correspondant à l'axe de rotation dudit deuxième élément inertiel massif 5, laquelle distance non nulle est comprise entre 0.1 fois et 0.2 fois la longueur totale L de la projection, sur le plan d'oscillation, de la lame 31, 32.

De façon similaire et particulière, quand le pivot 1 est symétrique par rapport à l'axe de symétrie AA, le centre de masse du premier élément support rigide 4 est situé, en projection sur le plan d'oscillation, sur l'axe de symétrie AA du pivot 1 et à une distance non nulle du point de croisement P correspondant à l'axe de rotation du deuxième élément inertiel massif 5. Notamment cette distance non nulle est comprise entre 0.1 fois et 0.2 fois la longueur totale L de la projection, sur le plan d'oscillation, de la lame 33, 34.

De façon similaire et particulière, quand le pivot 1 est symétrique par rapport à l'axe de symétrie AA, le centre de masse du premier élément support rigide 4 est situé, en projection sur le plan d'oscillation, sur l'axe de symétrie AA du pivot 1 et à une distance non nulle du point de croisement correspondant à l'axe de rotation du premier élément support rigide 4 laquelle distance non nulle est comprise entre 0.1 fois et 0.2 fois la longueur totale L de la projection, sur le plan d'oscillation, de la lame 31, 32.

De façon similaire et particulière, le centre de masse du premier élément support rigide 4 est situé sur l'axe de symétrie AA du pivot 1 et à la distance non nulle du point de croisement P laquelle est comprise entre 0.1 fois et 0.2 fois la longueur totale L de la projection, sur le plan d'oscillation, de la lame 33, 34.

De façon similaire et selon l'invention, le centre de masse de l'oscillateur 100 dans sa position de repos est distant du point de croisement P d'un écart $\varepsilon$ qui est compris entre 10% et 20% de la longueur totale L de la projection, sur le plan d'oscillation, de la lame 31 ; 32. Plus particulièrement, l'écart $\varepsilon$ est compris entre 12% et 18% de la longueur totale L de la projection, sur le plan d'oscillation, de la lame 31, 32.

Plus particulièrement, et tel que visible sur la variante des figures, quand le pivot 1 est symétrique par rapport à l'axe de symétrie AA, en projection sur le plan d'oscillation, le centre de masse de l'oscillateur 100 dans sa position de repos est situé sur l'axe de symétrie AA.

Plus particulièrement, le deuxième élément inertiel massif 5 est allongé selon la direction de l'axe de symétrie AA du pivot 1, quand le pivot 1 est symétrique par rapport à l'axe de symétrie AA. C'est par exemple le cas des figures 1 à 4 où l'élément inertiel 5 comporte une embase sur laquelle est fixé un balancier traditionnel à bras longs pourvus de tronçons de serge ou de masselottes en arc de cercle. L'objectif est de minimiser l'influence des accélérations angulaires externes autour de l'axe de symétrie du pivot, car les lames ont une faible rigidité en rotation autour de cet axe à cause du petit angle a.

L'invention se prête bien à une exécution monolithique des lames et des composants massifs qu'elles joignent, en matériau micro-usinable ou au moins partiellement amorphe, avec une mise en œuvre par procédé « MEMS » ou « LIGA » ou similaire. En particulier, dans le cas d'une exécution en silicium, l'oscillateur 100 est avantageusement compensé thermiquement par ajout de dioxyde de silicium sur des lames flexibles en silicium. Dans une variante, les lames peuvent être assemblées, par exemple encastrées dans des rainures, ou autre.

Lorsque on a deux pivots en série, comme dans le cas des figures 6 à 9, on peut mettre le centre de masse sur l'axe de rotation, dans le cas où l'agencement est choisi pour que les déplacements parasites se compensent, ce qui constitue une variante particulière qui ne fait pas partie de l'invention. Il convient toutefois de remarquer qu'il n'est pas nécessaire de choisir un tel agencement, et un tel oscillateur peut fonctionner avec deux pivots en série sans pour autant positionner le centre de masse sur l'axe de rotation. Bien sûr, même si les réalisations illustrées correspondent à des configurations géométriques particulières d'alignement, ou de symétrie, on comprend qu'il est aussi possible d'empiler deux pivots différents, ou avec des points de croisement différents, ou avec des centres de masses non alignés, ou encore de mettre en oeuvre un nombre supérieur de jeux de lames en série, avec des masses intermédiaires, pour augmenter encore l'amplitude du balancier.

Les variantes illustrées comportent tous les axes de pivotement, croisements de lames, et centres de masse, coplanaires, ce qui est un cas particulier avantageux, mais non limitatif.

On comprend que l'invention permet d'obtenir une course angulaire qui est grande: en tous les cas supérieure à 30°, elle peut même atteindre 50° voire 60°, ce qui la rend compatible en combinaison avec tous les échappements mécaniques usuels, ancre suisse, détente, co-axial, ou autre.

L'invention concerne encore un mouvement d'horlogerie 1000 comportant au moins un tel oscillateur 100 mécanique.

L'invention concerne encore une montre 2000 comportant au moins un tel mouvement d'horlogerie 1000.

**Revendications**

1. Oscillateur mécanique (100) d'horlogerie, comportant un premier élément support rigide (4), un deuxième élément inertiel massif (5), et, entre ledit premier élément support rigide (4) et ledit deuxième élément inertiel massif (5) au moins deux premières lames flexibles (31 ; 32) qui supportent ledit deuxième élément inertiel massif (5) et sont agencées pour le rappeler vers une position de repos, ledit deuxième élément inertiel massif (5) étant agencé pour osciller angulairement selon un plan d'oscillation autour de ladite position de repos, lesdites deux premières lames flexibles (31 ; 32) ne se touchant pas et leurs projections sur ledit plan d'oscillation se croisant, en position de repos, en un point de croisement (P), par lequel passe l'axe de rotation dudit deuxième élément inertiel massif (5) perpendiculairement audit plan d'oscillation, et les encastrements desdites premières lames flexibles (31 ; 32) avec ledit premier élément support rigide (4) et ledit deuxième élément inertiel massif (5) définissant deux directions de lames (DL1 ; DL2) parallèles audit plan d'oscillation et faisant entre elles, en position de repos, en projection sur ledit plan d'oscillation, un angle au sommet (a), où la position dudit point de croisement (P) est définie par le rapport X= D/L où D est la distance entre la projection, sur ledit plan d'oscillation, de l'un des points d'encastrement desdites premières lames (31 ; 32) dans ledit premier élément de support rigide (4) et ledit point de croisement (P), et où L est la longueur totale de la projection, sur ledit plan d'oscillation, de ladite lame (31 ; 32), et où la valeur dudit rapport D/L est comprise entre 0 et 1, et où ledit angle au sommet (a) est inférieur ou égal à 70°, dans lequel lesdites premières lames (31 ; 32) et leurs encastrements définissent ensemble un pivot (1) qui, en projection sur ledit plan d'oscillation, est symétrique 25 par rapport à un axe de symétrie (AA) passant par ledit point de croisement (P), dans lequel, en position de repos, en projection sur ledit plan d'oscillation, le centre de masse dudit deuxième élément inertiel massif (5) est situé sur ledit axe de symétrie (AA) dudit pivot (1), et **caractérisé en ce que**, en projection sur ledit plan d'oscillation, le centre de masse dudit deuxième élément inertiel massif (5) est à une distance non nulle dudit point de croisement (P) correspondant à l'axe de rotation dudit deuxième élément inertiel massif (5), laquelle distance non nulle est comprise entre 0.1 fois et 0.2 fois ladite longueur totale L de la projection, sur ledit plan d'oscillation, de ladite lame (31 ; 32).

2. Oscillateur mécanique (100) selon la revendication 1, **caractérisé en ce que** lesdites premières lames (31 ; 32) sont des lames droites.

3. Oscillateur mécanique (100) selon la revendication 1 ou 2, **caractérisé en ce que** ledit angle au sommet (a) est inférieur ou égal à 60°.

4. Oscillateur mécanique (100) selon la revendication 3, **caractérisé en ce que** ledit angle au sommet (a) est inférieur ou égal à 50°.

5. Oscillateur mécanique (100) selon la revendication 4, **caractérisé en ce que** ledit angle au sommet (a) est inférieur ou égal à 40°.

6. Oscillateur mécanique (100) selon la revendication 5, **caractérisé en ce que** ledit angle au sommet (a) est inférieur ou égal à 35°.

7. Oscillateur mécanique (100) selon la revendication 6, **caractérisé en ce que** ledit angle au sommet (a) est inférieur ou égal à 30°.

8. Oscillateur mécanique (100) selon l'une des revendications 1 à 7, **caractérisé en ce que**, pour chaque dite première lame flexible (31 ; 32), le rapport d'encastrement (D1/L1 ; D2/L2) est compris entre 0.15 et 0.85, bornes comprises.

9. Oscillateur mécanique (100) selon la revendication 8, **caractérisé en ce que** ledit rapport d'encastrement (D1/L1 ; D2/L2) est compris entre 0.15 et 0.49, bornes comprises, ou entre 0.51 et 0.85, bornes comprises.

10. Oscillateur mécanique (100) selon la revendication 4 et selon la revendication 8 ou 9, **caractérisé en ce que** ledit rapport d'encastrement (D1/L1 ; D2/L2) est compris entre 0.25 et 0.75, bornes comprises.

11. Oscillateur mécanique (100) selon la revendication 5 et selon la revendication 8 ou 9, **caractérisé en ce que** ledit rapport d'encastrement (D1/L1 ; D2/L2) est compris entre 0.30 et 0.70, bornes comprises.

12. Oscillateur mécanique (100) selon la revendication 6 et selon la revendication 8 ou 9, **caractérisé en ce que** ledit rapport d'encastrement (D1/L1 ; D2/L2) est compris entre 0.40 et 0.60, bornes comprises.

13. Oscillateur mécanique (100) selon l'une des revendications 1 à 12, **caractérisé en ce que** ledit angle au sommet (a) et ledit rapport X= D/L satisfont la relation :

$h1(D/L) < \alpha < h2(D/L)$, avec,
pour $0.2 \leq X < 0.5$ :

$$h1(X)= 116 - 473*(X + 0.05) + 3962*(X + 0.05)^3 - 6000*(X + 0.05)^4,$$

$$h2(X)=128 - 473*(X - 0.05) + 3962*(X - 0.05)^3 - 6000*(X - 0.05)^4,$$

pour $0.5 < X \leq 0.8$:

$$h1(X)= 116 - 473*(1.05 - X) + 3962*(1.05 - X)^3 - 6000*(1.05 - X)^4,$$

$$h2(X)=128 - 473*(0.95 - X) + 3962*(0.95 - X)^3 - 6000*(0.95 - X)^4.$$

14. Oscillateur mécanique (100) selon l'une des revendications 1 à 13, **caractérisé en ce que** lesdites premières lames flexibles (31 ; 32) ont la même longueur L, et la même distance D.

15. Oscillateur mécanique (100) selon la revendication 14, **caractérisé en ce que**, entre leurs encastrements, lesdites premières lames flexibles (31 ; 32) sont identiques.

16. Oscillateur mécanique (100) selon l'une des revendications 1 à 15, **caractérisé en ce que** ledit premier élément support rigide (4) est aussi mobile, directement ou indirectement par rapport à une structure fixe que comporte ledit oscillateur (100), et est porté par un troisième élément rigide (6) par deux secondes lames flexibles (33 ; 34) agencées de façon similaire audites premières lames flexibles (31 ; 32).

17. Oscillateur mécanique (100) selon la revendication 16, **caractérisé en ce que** les projections desdites premières lames flexibles (31 ; 32) et desdites secondes lames flexibles (33 ; 34) sur ledit plan d'oscillation se croisent au même dit point de croisement (P).

18. Oscillateur mécanique (100) selon la revendication 16, **caractérisé en ce que**, en position de repos, en projection sur ledit plan d'oscillation, les projections desdites premières lames flexibles (31 ; 32) et desdites secondes lames flexibles (33 ; 34) sur ledit plan d'oscillation se croisent en deux points distincts tous deux situés sur ledit axe de symétrie (AA) dudit pivot (1).

19. Oscillateur mécanique (100) selon l'une des revendications 16 à 18, **caractérisé en ce que** les encastrements desdites secondes lames flexibles (33 ; 34) avec ledit premier élément support rigide (4) et ledit troisième élément rigide (6) définissent deux directions de lames parallèles audit plan d'oscillation et faisant entre elles, en projection sur ledit plan d'oscillation, le même dit angle au sommet (a) que lesdites premières lames flexibles (31 ; 32).

20. Oscillateur mécanique (100) selon l'une des revendications 16 à 19, **caractérisé en ce que** lesdites secondes lames flexibles (33 ; 34) sont identiques auxdites premières lames flexibles (31 ; 32).

21. Oscillateur mécanique (100) selon l'une des revendications 16 à 20, **caractérisé en ce que**, en position de repos, en projection sur ledit plan d'oscillation, le centre de masse dudit deuxième élément inertiel massif (5) est situé sur ledit axe de symétrie (AA) dudit pivot (1).

22. Oscillateur mécanique (100) selon les revendications 17 et 21, **caractérisé en ce que**, en position de repos, les projections desdites premières lames flexibles (31; 32), et desdites secondes lames flexibles (33; 34), sur le plan d'oscillation se croisent au même point de croisement (P), qui correspond aussi à la projection du centre de masse dudit deuxième élément inertiel massif (5).

23. Oscillateur mécanique (100) selon l'une des revendications 1 à 22, **caractérisé en ce que** le centre de masse dudit oscillateur (100) dans sa position de repos est distant dudit point de croisement (P) d'un écart ($\varepsilon$) qui est compris entre 10% et 20% de la ladite longueur totale L de la projection, sur ledit plan d'oscillation, de ladite lame (31 ; 32).

24. Oscillateur mécanique (100) selon la revendication 23, **caractérisé en ce que** ledit écart ($\varepsilon$) est compris entre 12% et 18% de ladite longueur totale L de la projection, sur ledit plan d'oscillation, de ladite lame (31 ; 32).

**25.** Oscillateur mécanique (100) selon l'une des revendications 1 à 24, **caractérisé en ce que** ledit centre de masse dudit oscillateur (100) dans sa position de repos est situé sur ledit axe de symétrie (AA).

**26.** Oscillateur mécanique (100) selon l'une des revendications 1 à 25, **caractérisé en ce que** ledit deuxième élément inertiel massif (5) est allongé selon la direction de l'axe de symétrie (AA) dudit pivot (1).

**27.** Mouvement d'horlogerie (1000) comportant au moins un oscillateur (100) mécanique selon l'une des revendications 1 à 26.

**28.** Montre (2000) comportant au moins un mouvement d'horlogerie (1000) selon la revendication 27.


**Patentansprüche**

**1.** Mechanischer Uhrenoszillator (100), umfassend ein erstes steifes Tragelement (4), ein zweites vollwandiges Trägheitselement (5) und zwischen dem ersten steifen Tragelement (4) und dem zweiten vollwandigen Trägheitselement (5) mindestens zwei erste flexible Arme (31; 32), die das zweite vollwandige Trägheitselement (5) tragen und dazu vorgesehen sind, es in eine Ruheposition zurückzustellen, wobei das zweite vollwandige Trägheitselement (5) dazu vorgesehen ist, in Winkelrichtung in einer Schwingungsebene um die Ruheposition zu schwingen, wobei sich die beiden ersten flexiblen Arme (31; 32) nicht berühren und sich ihre Projektionen auf die Schwingungsebene in der Ruheposition an einem Kreuzungspunkt (P) kreuzen, durch den die Drehachse des zweiten vollwandigen Trägheitselements (5) senkrecht zur Schwingungsebene verläuft, und die Zapfenlager der ersten flexiblen Arme (31; 32) an dem ersten steifen Tragelement (4) und an dem zweiten vollwandigen Trägheitselement (5) zwei Armrichtungen (DL1; DL2) definieren, die zu der Schwingungsebene parallel sind und in der Ruheposition und in der Projektion auf die Schwingungsebene zwischen sich einen Scheitelwinkel (a) bilden, wobei die Position des Kreuzungspunkts (P) durch das Verhältnis X = D/L definiert ist, wobei D der Abstand zwischen der Projektion auf die Schwingungsebene eines der beiden Lagerstellen der ersten Arme (31; 32) in dem ersten steifen Tragelement (4) und dem Kreuzungspunkt (P) ist und wobei L die Gesamtlänge der Projektion auf die Schwingungsebene des Armes (31; 32) ist und wobei der Wert des Verhältnisses D/L zwischen 0 und 1 liegt und wobei der Scheitelwinkel (a) kleiner oder gleich 70° ist, wobei die ersten Arme (31; 32) und ihre Zapfenlager zusammen einen Drehzapfen (1) definieren, der in der Projektion auf die Schwingungsebene in Bezug auf eine Symmetrieachse (AA), die durch den Kreuzungspunkt (P) verläuft, symmetrisch ist, wobei der Massenschwerpunkt des zweiten vollwandigen Trägheitselements (5) in der Ruheposition in der Projektion auf die Schwingungsebene auf der Symmetrieachse (AA) des Drehzapfens (1) liegt, und **dadurch gekennzeichnet, dass** sich der Massenschwerpunkt des zweiten vollwandigen Trägheitselements (5) in der Projektion auf die Schwingungsebene in einem von null verschiedenen Abstand von dem Kreuzungspunkt (P), der der Drehachse des zweiten vollwandigen Trägheitselements (5) entspricht, befindet, wobei der von null verschiedene Abstand zwischen der 0,1-fachen und der 0,2-fachen Gesamtlänge L der Projektion auf die Schwingungsebene des Armes (31; 32) liegt.

**2.** Mechanischer Oszillator (100) nach Anspruch 1, **dadurch gekennzeichnet, dass** die ersten Arme (31; 32) geradlinige Arme sind.

**3.** Mechanischer Oszillator (100) nach Anspruch 1 oder 2, **dadurch gekennzeichnet, dass** der Scheitelwinkel (a) kleiner oder gleich 60° ist.

**4.** Mechanischer Oszillator (100) nach Anspruch 3, **dadurch gekennzeichnet, dass** der Scheitelwinkel (a) kleiner oder gleich 50° ist.

**5.** Mechanischer Oszillator (100) nach Anspruch 4, **dadurch gekennzeichnet, dass** der Scheitelwinkel (a) kleiner oder gleich 40° ist.

**6.** Mechanischer Oszillator (100) nach Anspruch 5, **dadurch gekennzeichnet, dass** der Scheitelwinkel (a) kleiner oder gleich 35° ist.

**7.** Mechanischer Oszillator (100) nach Anspruch 6, **dadurch gekennzeichnet, dass** der Scheitelwinkel (a) kleiner oder gleich 30° ist.

**8.** Mechanischer Oszillator (100) nach einem der Ansprüche 1 bis 7, **dadurch gekennzeichnet, dass** für jeden ersten flexiblen Arm (31; 32) das Lagerverhältnis (D1/L1; D2/L2) zwischen 0,15 und 0,85 liegt, Grenzwerte eingeschlossen.

9. Mechanischer Oszillator (100) nach Anspruch 8, **dadurch gekennzeichnet, dass** das Lagerverhältnis (D1/L1; D2/L2) zwischen 0,15 und 0,49, Grenzwerte eingeschlossen, oder zwischen 0,51 und 0,85, Grenzwerte eingeschlossen, liegt.

10. Mechanischer Oszillator (100) nach Anspruch 4 und nach Anspruch 8 oder 9, **dadurch gekennzeichnet, dass** das Lagerverhältnis (D1/L1; D2/L2) zwischen 0,25 und 0,75 liegt, Grenzwerte eingeschlossen.

11. Mechanischer Oszillator (100) nach Anspruch 5 und nach Anspruch 8 oder 9, **dadurch gekennzeichnet, dass** das Lagerverhältnis (D1/L1; D2/L2) zwischen 0,30 und 0,70 liegt, Grenzwerte eingeschlossen.

12. Mechanischer Oszillator (100) nach Anspruch 6 und nach Anspruch 8 oder 9, **dadurch gekennzeichnet, dass** das Lagerverhältnis (D1/L1; D2/L2) zwischen 0,40 und 0,60 liegt, Grenzwerte eingeschlossen.

13. Mechanischer Oszillator (100) nach einem der Ansprüche 1 bis 12, **dadurch gekennzeichnet, dass** der Scheitelwinkel (a) und das Verhältnis X = D/L die folgende Beziehung erfüllen:

h1(D/L) < a < h2(D/L), wobei
für $0,2 \leq X \leq 0,5$:

$$h1(X) = 116 - 473*(X + 0,05) + 3962*(X + 0,05)^3 - 6000*(X + 0,05)^4,$$

$$h2(X) = 128 - 473*(X - 0,05) + 3962*(X - 0,05)^3 - 6000*(X - 0,05)^4,$$

für $0,5 < X \leq 0,8$:

$$h1(X) = 116 - 473*(1,05 - X) + 3962*(1,05 - X)^3 - 6000*(1,05 - X)^4,$$

$$h2(X) = 128 - 473*(0,95 - X) + 3962*(0,95 - X)^3 - 6000*(0,95 - X)^4.$$

14. Mechanischer Oszillator (100) nach einem der Ansprüche 1 bis 13, **dadurch gekennzeichnet, dass** die ersten flexiblen Arme (31; 32) dieselbe Länge L und denselben Abstand D haben.

15. Mechanischer Oszillator (100) nach Anspruch 14, **dadurch gekennzeichnet, dass** die ersten flexiblen Arme (31; 32) zwischen ihren Zapfenlagern identisch sind.

16. Mechanischer Oszillator (100) nach einem der Ansprüche 1 bis 15, **dadurch gekennzeichnet, dass** das erste starre Tragelement (4) in Bezug auf eine feste Struktur, die der Oszillator (100) umfasst, direkt oder indirekt ebenfalls beweglich ist und durch ein drittes steifes Element (6) durch zwei zweite flexible Arme (33; 34), die ähnlich wie die ersten flexiblen Arme (31; 32) beschaffen sind, getragen wird.

17. Mechanischer Oszillator (100) nach Anspruch 16, **dadurch gekennzeichnet, dass** sich die Projektionen der ersten flexiblen Arme (31; 32) und der zweiten flexiblen Arme (33; 34) auf die Schwingungsebene am selben Kreuzungspunkt (P) kreuzen.

18. Mechanischer Oszillator (100) nach Anspruch 16, **dadurch gekennzeichnet, dass** sich in der Ruheposition in der Projektion auf die Schwingungsebene die Projektionen der ersten flexiblen Arme (31; 32) und der zweiten flexiblen Arme (33; 34) auf die Schwingungsebene an unterschiedlichen Punkten kreuzen, die beide auf der Symmetrieachse (AA) des Drehzapfens (1) liegen.

19. Mechanischer Oszillator (100) nach einem der Ansprüche 16 bis 18, **dadurch gekennzeichnet, dass** die Zapfenlager der zweiten flexiblen Arme (33; 34) an dem ersten steifen Tragelement (4) und an dem dritten steifen Element (6) zwei Armrichtungen definieren, die zu der Schwingungsebene parallel sind und untereinander in der Projektion auf die Schwingungsebene denselben Scheitelwinkel (a) wie die ersten flexiblen Arme (31; 32) bilden.

20. Mechanischer Oszillator (100) nach einem der Ansprüche 16 bis 19, **dadurch gekennzeichnet, dass** die zweiten flexiblen Arme (33; 34) mit den ersten flexiblen Armen (31; 32) identisch sind.

21. Mechanischer Oszillator (100) nach einem der Ansprüche 16 bis 20, **dadurch gekennzeichnet, dass** in der Ruheposition in der Projektion auf die Schwingungsebene der Massenschwerpunkt des zweiten vollwandigen Trägheitselements (5) auf der Symmetrieachse (AA) des Drehzapfens (1) liegt.

22. Mechanischer Oszillator (100) nach den Ansprüchen 17 und 21, **dadurch gekennzeichnet, dass** sich in der Ruheposition die Projektionen der ersten flexiblen Arme (31; 32) und der zweiten flexiblen Arme (33; 34) auf die Schwingungsebene im selben Kreuzungspunkt (P) kreuzen, der auch der Projektion des Massenschwerpunkts des zweiten vollwandigen Trägheitselements (5) entspricht.

23. Mechanischer Oszillator (100) nach einem der Ansprüche 1 bis 22, **dadurch gekennzeichnet, dass** der Massenschwerpunkt des Oszillators (100) in seiner Ruheposition von dem Kreuzungspunkt (P) um eine Strecke ($\varepsilon$) entfernt ist, die zwischen 10 % und 20 % der Gesamtlänge L der Projektion auf die Schwingungsebene des Armes (31; 32) liegt.

24. Mechanischer Oszillator (100) nach Anspruch 23, **dadurch gekennzeichnet, dass** die Strecke ($\varepsilon$) zwischen 12 % und 18 % der Gesamtlänge L der Projektion auf die Schwingungsebene des Armes (31; 32) liegt.

25. Mechanischer Oszillator (100) nach einem der Ansprüche 1 bis 24, **dadurch gekennzeichnet, dass** der Massenschwerpunkt des Oszillators (100) in seiner Ruheposition auf der Symmetrieachse (AA) liegt.

26. Mechanischer Oszillator (100) nach einem der Ansprüche 1 bis 25, **dadurch gekennzeichnet, dass** das zweite vollwandige Trägheitselement (5) in Richtung der Symmetrieachse (AA) des Drehzapfens (1) verlängert ist.

27. Uhrwerk (1000), umfassend mindestens einen mechanischen Oszillator (100) nach einem der Ansprüche 1 bis 26.

28. Uhr (2000), umfassend mindestens ein Uhrwerk (1000) nach Anspruch 27.


**Claims**

1. Mechanical timepiece oscillator (100) including a first rigid support element (4), a second solid inertial element (5) and, between said first rigid support element (4) and said second solid inertial element (5), at least two first flexible strips (31; 32) which support said second solid inertial element (5) and are arranged to return the latter to a rest position, wherein said second solid inertial element (5) is arranged to oscillate angularly in an oscillation plane about said rest position, said two first flexible strips (31; 32) do not touch each other and their projections onto said oscillation plane intersect, in the rest position, at a crossing point (P), through which passes the axis of rotation of said second solid inertial element (5) perpendicularly to said oscillation plane, and the embedding points of said first flexible strips (31; 32) in said first rigid support element (4) and said second solid inertial element (5) define two strip directions (DL1; DL2), which are parallel to said oscillation plane and which form between them, in the rest position, in projection onto said oscillation plane, a vertex angle (a), the position of said crossing point (P) being defined by the ratio X= D/L, where D is the distance between the projection onto said oscillation plane of one of the embedding points of said first strips (31; 32) in said first rigid support element (4) and said crossing point (P), and where L is the total length of the projection, onto said oscillation plane, of said strip (31; 32), and where the value of said ratio D/L is comprised between 0 and 1, and where said vertex angle (a) is less than or equal to 70°, wherein said first strips (31; 32) and their embedding points define together a pivot (1) which, in projection onto said oscillation plane, is symmetrical with respect to an axis of symmetry (AA) passing through said crossing point (P), wherein in the rest position, in projection onto said oscillation plane, the centre of mass of said second solid inertial element (5) is located on said axis of symmetry (AA) of said pivot (1), and **characterised in that**, in projection onto said oscillation plane, the centre of mass of said second solid inertial element (5) is at a non-zero distance from said crossing point (P) corresponding to the axis of rotation of said second solid inertial element (5), which non-zero distance is comprised between 0.1 times and 0.2 times the total length (L) of the projection, onto said oscillation plane, of said strip (31; 32).

2. Mechanical oscillator (100) according to claim 1, **characterised in that** said first strips (31; 32) are straight strips.

3. Mechanical oscillator (100) according to claim 1 or 2, **characterised in that** said vertex angle (a) is less than or equal to 60°,

4. Mechanical oscillator (100) according to claim 3, **characterised in that** said vertex angle (a) is less than or equal to 50°,

5. Mechanical oscillator (100) according to claim 4, **characterised in that** said vertex angle (a) is less than or equal to 40°,

6. Mechanical oscillator (100) according to claim 5, **characterised in that** said vertex angle (a) is less than or equal to 35°,

7. Mechanical oscillator (100) according to claim 6, **characterised in that** said vertex angle (a) is less than or equal to 30°,

8. Mechanical oscillator (100) according to one of claims 1 to 7, **characterised in that**, for each said first flexible strip (31; 32), the embedding point ratio (D1/L1; D2/L2) is comprised between 0.15 and 0.85 inclusive.

9. Mechanical oscillator (100) according to claim 8, **characterised in that** said embedding point ratio (D1/L1; D2/L2) is comprised between 0.15 and 0.49 inclusive, or between 0.51 and 0.85 inclusive.

10. Mechanical oscillator (100) according to claim 4 and according to claim 8 or 9, **characterised in that** said embedding ratio (D1/L1; D2/L2) is comprised between 0.25 and 0.75 inclusive.

11. Mechanical oscillator (100) according to claim 5 and according to claim 8 or 9, **characterised in that** said embedding point ratio (D1/L1; D2/L2) is comprised between 0.30 and 0.70 inclusive.

12. Mechanical oscillator (100) according to claim 6 and according to claim 8 or 9, **characterised in that** said embedding point ratio (D1/L1; D2/L2) is comprised between 0.40 and 0.60 inclusive.

13. Mechanical oscillator (100) according to one of claims 1 to 12, **characterised in that** said apex angle (a) and said ratio X= D/L satisfy the relation h1(D/L) < a< h2(D/L), where,
for $0.2 \geq X < 0.5$:

$$h1(X)= 116 - 473*(X + 0.05) + 3962*(X + 0.05)^3 - 6000*(X + 0.05)^4,$$

$$h2(X)=128 - 473*(X - 0.05) + 3962*(X - 0.05)^3 - 6000*(X - 0.05)^4,$$

for $0.5 < X \geq 0.8$:

$$h1(X)= 116 - 473*(1.05 - X) + 3962*(1.05 - X)^3 - 6000*(1.05 - X)^4,$$

$$h2(X)=128 - 473*(0.95 - X) + 3962*(0.95 - X)^3 - 6000*(0.95 - X)^4.$$

14. Mechanical oscillator (100) according to one of claims 1 to 13, **characterised in that** said first flexible strips (31; 32) have the same length L and the same distance D.

15. Mechanical oscillator (100) according to claim 14, **characterised in that**, between their embedding points, said first flexible strips (31; 32) are identical.

16. Mechanical oscillator (100) according to one of claims 1 to 15, **characterised in that** said first rigid support element (4) is also directly or indirectly movable with respect to a stationary structure comprised in said oscillator (100), and is carried by a third rigid element (6), by means of two second flexible strips (33, 34) arranged in a similar manner to said first flexible strips (31; 32).

**17.** Mechanical oscillator (100) according to claim 16, **characterised in that** the projections of said first flexible strips (31; 32) and of said second flexible strips (33; 34) onto said oscillation plane intersect at the same said crossing point (P).

**18.** Mechanical oscillator (100) according to claim 16, **characterised in that**, in the rest position, in projection onto said oscillation plane, the projections of said first flexible strips (31; 32) and of said second flexible strips (33, 34) onto said oscillation plane intersect at two distinct points both located on said axis of symmetry (AA) of said pivot (1).

**19.** Mechanical oscillator (100) according to one of claims 16 to 18, **characterised in that** the embedding points of said second flexible strips (33; 34) in said first rigid support element (4) and said third rigid element (6) define two strip directions that are parallel to said oscillation plane and form between them, in projection onto said oscillation plane, the same said vertex angle (a) as said first flexible strips (31; 32).

**20.** Mechanical oscillator (100) according to one of claims 16 to 19, **characterised in that** said second flexible strips (33; 34) are identical to said first flexible strips (31; 32).

**21.** Mechanical oscillator (100) according to one of claims 16 to 20, **characterised in that**, in the rest position, in projection onto said oscillation plane, the centre of mass of said second solid inertial element (5) is located on said axis of symmetry (AA) of said pivot (1).

**22.** Mechanical oscillator (100) according to one of claims 17 and 21, **characterised in that**, in the rest position, the projections of said first flexible strips (31; 32) and of said second flexible strips (33; 34), onto the oscillation plane intersect at the same crossing point (P), which also corresponds to the projection of the centre of mass of said second solid inertial element (5).

**23.** Mechanical oscillator (100) according to one of claims 1 to 22, **characterised in that** the centre of mass of said oscillator (100) in the rest position thereof is distant from said crossing point (P) by a difference ($\varepsilon$) that is comprised between 10% and 20% of said total length L of the projection, onto said oscillation plane, of said strip (31; 32).

**24.** Mechanical oscillator (100) according to claim 23, **characterised in that** said difference ($\varepsilon$) is comprised between 12% and 18% of said total length L of the projection, onto said oscillation plane, of said strip (31; 32).

**25.** Mechanical oscillator (100) according to one of claims 1 to 24, **characterised in that** said centre of mass of said oscillator (100) in its rest position is located on said axis of symmetry (AA).

**26.** Mechanical oscillator (100) according to one of claims 1 to 25, **characterised in that** said second solid inertial element (5) is elongated in the direction of the axis of symmetry (AA) of said pivot (1).

**27.** Timepiece movement (1000) including at least one mechanical oscillator (100) according to one of claims 1 to 26.

**28.** Watch (2000) including at least one timepiece movement (1000) according to claim 27.

Fig. 1

Fig. 2

Fig. 3

Fig. 4

Fig. 5

Fig. 9

Fig. 6

Fig. 7

Fig. 8

## RÉFÉRENCES CITÉES DANS LA DESCRIPTION

**Documents brevets cités dans la description**

- EP 14199039 A
- EP 16155039 A
- EP 3035127 A1
- US 3628781 A
- EP 3130966 A1
- CH 709536 A2